# EUROPÄISCHE PATENTSCHRIFT

(11) **EP 1 382 114 B1**
(45) Veröffentlichungstag und Bekanntmachung des Hinweises auf die Patenterteilung: **22.09.2004**
(21) Anmeldenummer: 02726075.1
(22) Anmeldetag: 03.04.2002
(51) Int. Cl.: H03G 1/00

(54) **SCHALTUNGSANORDNUNG UND VERFAHREN ZUR ARBEITSPUNKTEINSTELLUNG EINES LEISTUNGSVERSTÄRKERS**
CIRCUIT ARRANGEMENT AND METHOD FOR ADJUSTING THE OPERATING POINT OF A POWER AMPLIFIER
CIRCUIT ET PROCEDE POUR REGLER LE POINT DE FONCTIONNEMENT D'UN AMPLIFICATEUR DE PUISSANCE

(30) Priorität: 26.04.2001 DE 10120514
(43) Veröffentlichungstag der Anmeldung: 21.01.2004
(73) Patentinhaber: SIEMENS AKTIENGESELLSCHAFT, 80333 München (DE)
(72) Erfinder: BOLLENBECK, Jan, 91330 Eggolsheim (DE)
(86) Internationale Anmeldenummer: PCT/DE2002/001190
(87) Internationale Veröffentlichungsnummer: WO 2002/089323

(56) Entgegenhaltungen:
- EP-A- 0 665 657
- EP-A- 0 896 439

## Beschreibung

Die Erfindung betrifft eine Schaltungsanordnung und ein Verfahren zur Arbeitspunkteinstellung des Leistungsverstärkers, vorzugsweise eines mobilen Telekommunikationsendgerätes, mit Modulationsverfahren mit nichtkonstanter Hüllkurve.

Moderne Mobilfunk-Standards sehen zum Teil Modulationsverfahren mit nichtkonstanter Hüllkurve vor. Hier sind insbesondere der UMTS-Standard mit W-CDMA (Wideband-Code Division Multiple Access = Breitband Codemultiplex Vielfachzugriff) beziehungsweise HPSK-Modulation (HPSK = Hybrid Phase Shift Keying) sowie der EDGE-Standard (EDGE = Enhanced Datarate for GSM Evolution) mit 3Π/8 offset 8PSK - Modulation zu nennen.

Die verzerrungsfreie Verstärkung von amplitudenmodulierten HF-Signalen ist im allgemeinen, ohne Verwendung von besonderen Verfahren, nur mit streng linearen Verstärkerelementen möglich.

Nichtlinearitäten in der Verstärkerkennlinie führen zu Amplitudenverzerrungen sowie aufgrund von AM zu PM-Konversion zu Phasenverzerrungen des Verstärker-Ausgangssignals. Die über die modernen Mobilfunk-Standards definierten digitalen Modulationsverfahren reagieren sehr empfindlich auf hierdurch hervorgerufene Übertragungsfehler. Zudem wird das Sendespektrum zusätzlich durch Intermodulation, vornehmlich dritter und fünfter Ordnung, unerwünscht aufgeweitet.

Die durch Spezifikationen festgelegten Grenzen der zulässigen Amplituden- und Phasenfehler und insbesondere der Nachbarkanalleistung (ACP: Adjacent Channel Power) beziehungsweise des Verhältnisses von Nachbarkanalleistung zu Nutzkanalleistung (ACLR: Adjacent Channel Leakage Ratio) können nur mit sorgfältig ausgelegten Sendeverstärkern eingehalten werden.

Der notwendige lineare Betrieb eines Verstärkers setzt voraus, daß der 1dB Ausgangskompressionspunkt des Verstärkers deutlich oberhalb des Spitzenleistungspegels des Ausgangssignals liegt. Bei der Auslegung sämtlicher Verstärkerstufen und Bias - Ströme / Versorgungsspannungen ist diese Anforderung zu berücksichtigen.

Wird ein derartiger Verstärker für die maximal bereitzustellende Ausgangsleistung dimensioniert, so ergibt sich bei kleinen Leistungspegeln eine unnötig hohe Stromaufnahme. Der Wirkungsgrad des Leistungsverstärkers sinkt mit kleiner werdenden Augangsleistungspegeln schnell ab.

Speziell bei Geräten welche nach dem UMTS-Standard arbeiten, ist auf eine geringe Stromaufnahme des Senders zu achten, da der Sender hier in einem kontinuierlichen Modus (Vollduplex) betrieben wird und sich daher ein ungünstiger Wirkungsgrad besonders stark auf die maximal mögliche Betriebsdauer des verwendeten Akkus auswirkt.

In einer bisher allgemein bekannten Ausführung wurde beispielsweise die Stellung des Leistungsverstärkers - Bias /Spannungsversorgung in Abhängigkeit vom Ausgangsleistungspegel in einer sogenannten "Look Up" -Tabelle niedergelegt, deren Werte zuvor in Versuchsreihen definiert wurden. Dies erfordert einen hohen Abgleichaufwand in der Fertigung, großen Speicherbedarf und die Alterung des Gerätes kann nicht abgefangen werden.

Eine andere bekannte Variante ist in der EP 896 439 A2 offenbart, in der ein Vergleich der Stromaufnahme einzelner Transistorstufen mit einer von der erwarteten Ausgangsleistung abhängigen Sollgröße und Nachführung der Transistorarbeitspunkte vorgeschlagen wird. Nachteilig ist auch hier ein hoher Abgleichaufwand und Speicherbedarf, wobei der Frequenzgang ebenfalls nur über eine "Look Up"-Tabelle kompensiert werden kann.

Es ist daher Aufgabe der Erfindung eine Möglichkeit zur automatischen Einstellung des Arbeitspunktes des Leistungsverstärkers eines mobilen Telekommunikationsendgerätes mit Modulationsverfahren mit nichtkonstanter Hüllkurve zu finden, die den Arbeitspunkt immer gerade so einstellt, daß die ACLR-Anforderungen noch erfüllt werden.

Diese Aufgabe wird durch die Merkmale der unabhängigen Patentansprüche gelöst. Vorteilhafte Weiterbildungen der Erfindung sind Gegenstand untergeordneter Ansprüche.

Demgemäß schlägt der Erfinder zur Arbeitspunkteinstellung des Leistungsverstärkers eines mobilen Telekommunikationsendgerätes mit Modulationsverfahren mit nichtkonstanter Hüllkurve eine Schaltungsanordnung, vor, mit Mitteln zur Erzeugung eines Sendesignals auf einem Nutzkanal - im folgenden Nutzkanalsignal genannt -, wobei durch Verzerrungen in nachfolgenden Verstärkern auch auf Nachbarkanälen Signalanteile - im folgenden Nachbarkanalsignal genannt - entstehen und einem in seinem Arbeitspunkt einstellbaren Leistungsverstärker zur Verstärkung des Sendesignals, das an eine Antenne weitergeleitet wird, wobei ein Mittel zur Auskopplung eines Teils des verstärkten Sendesignals - im folgenden Teilsignal genannt - vorgesehen ist und dieses ausgekoppelte Teilsignal über ein Frequenz-Mischglied auf eine feste Zwischenfrequenz gemischt und mittels eines Zwischenfrequenzfilters gefiltert wird und ein Regelkreis vorgesehen ist, um den Leistungspegel dieses gefilterten Teilsignals auf einen vorbestimmten Wert zu halten. Weiterhin ist ein Filter zur Auskopplung des Nachbarkanalsignals aus dem konstant gehaltenen Teilsignal mit anschließendem Leistungsdetektor vorgesehen, über dessen Detektorausgangssignal der Arbeitspunkt des Leistungsverstärkers bezüglich Bias und Versorgungsspannung gesteuert wird.

Durch diese Schaltungsanordnung wird erreicht, daß der Arbeitspunkt gerade so eingestellt ist, daß das geforderte Verhältnis von Nachbarkanalsendeleistung zu Nutzkanalsendeleistung gerade erreicht wird, wodurch sich nur die gerade unbedingt notwendige Stromaufnahme des Sendeverstärkers einstellt. Hierdurch ergibt sich eine sehr energiesparende Einstellung ohne aufwendige Abgleichungen bei der Produktion des Gerätes und ohne kostenaufwendige Speicher für die sonst verwendeten "Look Up"-Tabellen. Da die Teilsignalleistung auf der Zwischenfrequenz mittels einer Regelschleife konstant gehalten wird, ist das Detektorausgangssignal ein direktes Maß für das momentane ACLR.

In einer bevorzugten Ausführungsform der Schaltungsanordnung schlägt der Erfinder vor, daß der Regelkreis zur Leistungsregelung des Teilsignals zumindest einen Verstärker (VGA), ein Dämpfungsglied, einen Leistungsdetektor, einen Operationsverstärker (Integrator) und ein Tiefpaßfilter aufweist.

Bei gepulsten Systemen, wie beispielsweise dem EDGE-System, ist zusätzlich ein Halteglied erforderlich, auf welches bei Systemen wie dem UMTS, welche in einem kontinuierlichen Modus arbeiten, verzichtet werden kann.

Wie bereits angedeutet kann die erfindungsgemäße Schaltungsanordnung bevorzugt für die Verwendung in einem CDMA-Handy (CDMA = code division multiple access = Codemultiplex Vielfachzugriff) oder TDMA-Handy (TDMA = time division multiple access = Zeitmultiplex Vielfachzugriff) genutzt werden.

Entsprechend dem Erfindungsgedanken schlägt der Erfinder auch ein Verfahren zur Arbeitspunkteinstellung des Leistungsverstärkers eines mobilen Telekommunikationsendgerätes mit einem Modulationsverfahren mit nichtkonstanter Hüllkurve, vor, in dem ein Teil eines verstärkten Sendesignals - nachfolgend Teilsignal genannt -, enthaltend ein Nutzkanalsignal und ein Nachbarkanalsignal, ausgekoppelt, auf eine feste Zwischenfrequenz gemischt, mittels eines Zwischenfrequenzfilters gefiltert, in einem Regelkreis auf einen vorbestimmten Pegel verstärkt und in Abhängigkeit der Leistung des darin enthaltenen Nachbarkanalsignals der Arbeitspunkt des Leistungsverstärkers geregelt wird.

Vorteilhaft ist es dabei, wenn zur Reglung des Arbeitspunktes des Leistungsverstärkers die Parameter Basisstrom und Versorgungsspannung bei Bipolartransistoren oder Gate-Spannung und Versorgungsspannung bei Feldeffekttransistoren von vorgegebenen Ausgangswerten, mit denen die Anforderungen an das Nachbarkanalsignal/Nutzkanalsignal-Verhältnis sicher erfüllt wird, startend sukzessive solange verringert werden, bis gerade das Nachbarkanalsignal/Nutzkanalsignal-Verhältnis der Spezifikation, gegebenenfalls abzüglich einer vorgegebenen Sicherheit, entspricht.

Die Mischung des Teilsignals kann auch direkt in das Basisband erfolgen.

Des weiteren sollte vorteilhaft die Regelgeschwindigkeit des Regelkreises für den Pegelbereich des Teilsignals so bemessen werden, daß die Regelung von einer Amplitudenmodulation des Sendesignals unbeeinflußt bleibt.

Im folgenden wird die Erfindung anhand eines bevorzugten Ausführungsbeispieles mit Hilfe der Figuren näher beschrieben. Es zeigen im einzelnen:
- Figur 1:: Idealisiertes Ausgangskennlinienfeld einer Leistungstransistorstufe;
- Figur 2:: AM/PM eines 1W 1,9GHz GaAs MESFET;
- Figur 3:: Erfindungsgemäße Schaltungsanordnung;
- Figur 4:: Verlauf eines Sende-Bursts eines EDGE-Systems;
- Figur 5:: Senderarchitektur mit ACLR-Detektion.

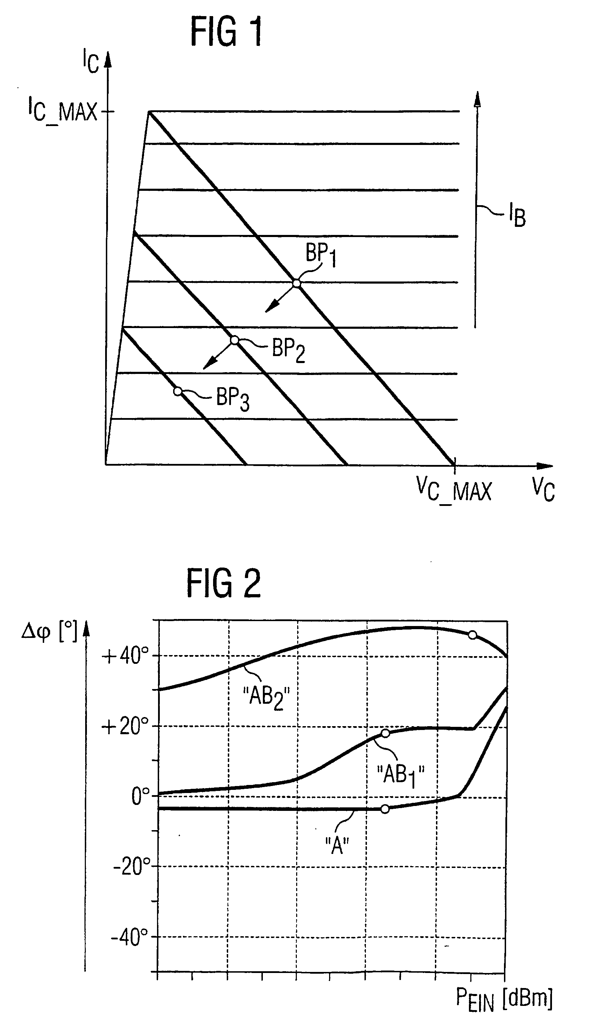

In der Figur 1 ist das idealisierte Ausgangskennlinienfeld einer Leistungstransistorstufe dargestellt. Eingetragen sind die "Loadlines" (=Ladelinie) für drei verschiedene Versorgungsspannungen, welche jeweils die erforderliche Lastimpedanz definiert und sich aus den Größen Ausgangsleistung, Knie-Punkt (Kollektor- beziehungsweise Drain-Strom und Spannung im Kennlinienknick) und Versorgungsspannung ergibt. Der Arbeitspunkt BP (=Bias Point) auf der Loadline L wird durch den eingestellten Basisstrom eines Bipolar Transistors beziehungsweise die eingestellte Gatespannung eines Feldeffekt Transistors bestimmt. Geht man von einer symmetrischen Aussteuerung um den Arbeitspunkt im A- beziehungsweise AB-Betrieb - entsprechend den jeweils verwendeten Verstärkerklassen A oder AB - aus, so stellen die Abszisse und das obere Ende der Loadline die Grenzen für lineare Verstärkung dar. Wird der Transistor stärker ausgesteuert, so wird das Ausgangssignal begrenzt und die Signalform wird verzerrt.

Wird die Versorgungsspannung V_{c} und/oder der Basisstrom I_{B} beziehungsweise die Gatespannung bei kleinen Ausgangsleistungen verringert, bleiben Signalform und Verstärkung unverändert, solange die Signalamplitude nicht strom- und/oder spannungsbegrenzt ("geclippt") wird.

Da sich die DC-Eingangsleistung der Stufe aus dem Produkt I_{c} x V_{c} ergibt, steigt der Wirkungsgrad mit sinkender Versorgungsspannung V_{c} und sinkendem Kollektor- beziehungsweise Drain-Ruhestrom bei gleichbleibender HF-Ausgangsleistung.

Es ist daher anzustreben, die Versorgungsspannung V_{c} und den Basisstrom I_{B} beziehungsweise die Gatespannung nur gerade so hoch einzustellen, wie es der quasi-lineare Betrieb des Verstärkers erfordert.

In realen Transistorstufen entstehen neben den Amplitudenverzerrungen (AM to AM conversion, AM/AM) auch Phasenverzerrungen (AM to PM conversion, AM/PM). Hierdurch werden neben zusätzlichen Intermodulations-Komponenten auch Beiträge zum sogenannten Fehlervektor erzeugt, wodurch die Zuordnung der Symbole im Entscheider des digitalen Empfängers erschwert wird und unter Umständen Bitfehler hervorgerufen werden. Amplitudenverzerrungen beziehungsweise Phasenverzerrungen entstehen aufgrund unterschiedlicher Mechanismen. Die Phasenverzerrung in Halbleiterbauelementen entsteht unter anderem an nichtlinearen spannungsabhängigen Kapazitäten.

Der Grad der Phasenverzerrung bei einer bestimmten Verstärkeraussteuerung hängt stark vom Betriebsmodus des Verstärkers ab. Beispielhaft ist dies in der Figur 2 für einen GaAs-MESFET-Verstärker wiedergegeben. Die Figur 2 wurde aus "S. C. Cripps, RF Power Amplifiers for Wireless Communications, Artech House Publishers 1999, Seite 204, ISBN O-89006-989-1, entnommen. Die Kreise markieren die jeweiligen P_{1dB-} Punkte. Das gezeigte Verhalten ist typisch, ändert sich jedoch von Halbleitertechnologie zu Halbleitertechnologie.

Man erkennt, daß im AB-Betrieb - gekennzeichnet mit AB₁ - bereits deutlich unterhalb des 1dB - Kompressionspunktes erhebliche Phasenverzerrungen entstehen. Im sogenannten "Deep Class AB Mode" - gekennzeichnet mit AB₂ - ändert sich die Phase beinahe linear mit der logarithmisch in dB aufgetragenen Eingangsleistung bis hin zum P_{1dB}-Punkt (1dB-Kompressionspunkt), an dem sich die Steigung umkehrt. Im "Class A Mode" bei "A" entstehen hingegen erst jenseits des P_{1dB}-Punktes signifikante AM/PM-Verzerrungen.

Es zeigt sich, daß die Phasenverzerrung bezüglich der Spektrumsaufweitung aufgrund von Intermodulation (Spectral Regrowth) einen wichtigen, jedoch selten einen dominierenden Effekt darstellt, der sich häufig in einem unsymmetrischen Verlauf des Intermodulations-Spektrums widerspiegelt. Bei der Einstellung des optimalen Transistorarbeitspunktes wird die Grenze im allgemeinen durch die Anforderungen an das ACLR bestimmt.

Die Schwierigkeit besteht nun darin, den jeweils optimalen Arbeitspunkt bezüglich Bias-Punkt BP und Versorgungsspannung V_{C}, bei dem die ACLR-Anforderungen gerade erfüllt werden, im Sendebetrieb zu bestimmen beziehungsweise einzustellen.

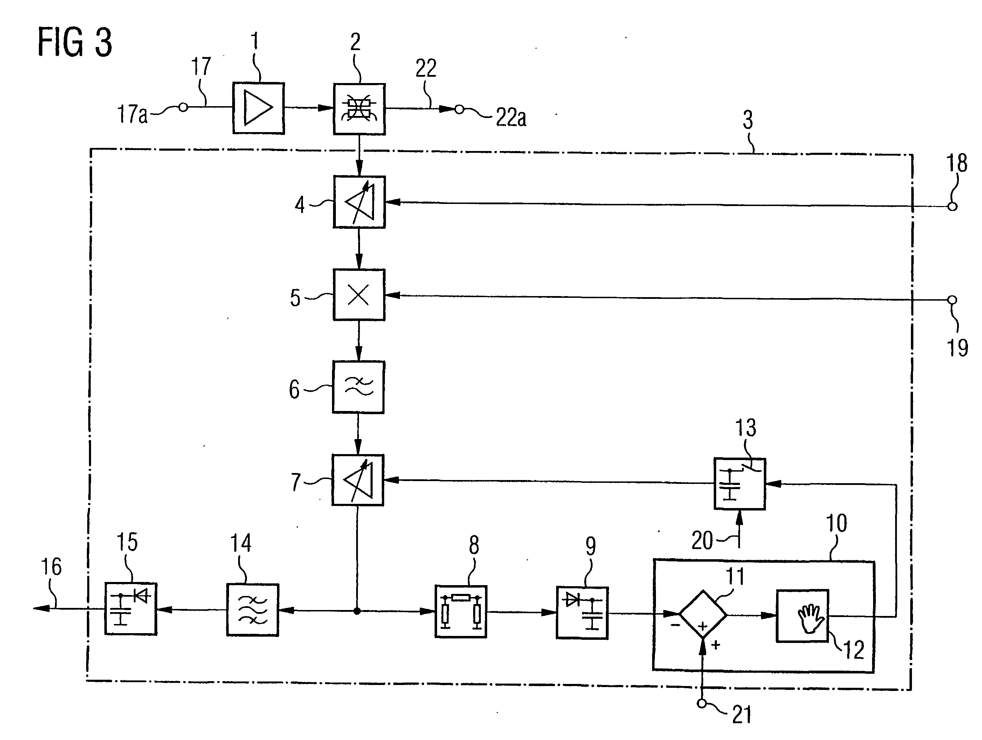

Die Figur 3 zeigt eine erfindungsgemäße Schaltungsanordnung, die eine vom ACLR des Sendesignals abhängige Detektor-Spannung generiert.

Hier wird ein Teil des Ausgangssignals aus dem Leistungsverstärker 1 mit einem Leistungskoppler 2 ausgekoppelt und als Teilsignal einem VGA (Variable Gain Amplifier) zugeführt. Über die steuerbare Verstärkung des VGAs wird der Eingangspegel des nachfolgenden Mischers 5 in einen definierten Bereich gebracht. Hierdurch reduzieren sich unter anderem die Großsignalanforderungen an die nachfolgenden Stufen. Die Steuergröße kann im Steuerteil aus der jeweils geforderten Soll-Sendeleistung des Senders bezogen auf den RF-Ausgang 22a abgeleitet werden.

Das Ausgangssignal aus dem Mischer 5 wird mit dem Filter 6 gefiltert und auf den Eingang eines zweiten VGAs 7 gegeben. Der Pegel des Ausgangssignals dieses Verstärkers 7 wird über eine Regelschleife, bestehend aus dem Dämpfungsglied 8, dem Leistungsdetektor 9, dem Operationsverstärker 10 mit Sammelpunkt 11 und Integrator 12 und (optional im EDGE Modus) dem Halteglied 13, konstant gehalten und das Teilsignal über ein Bandpaß-Filter 14 (Nachbarkanalfilter) auf einen Leistungsdetektor 15 gegeben. Der sich ergebende Detektor-Eingangs-Pegel kann über das Signal 21 "Detector Op.-Point" an die verwendeten Detektoren angepasst werden. Die Dämpfung des Dämpfungsgliedes 8 entspricht von seinem Wert dem des spezifizierten ACLRs. Hierdurch wird sichergestellt, daß am Detektor 9 der Regelschleife, der die Kanalleistung sieht, und am Detektor 15 der Nachbarkanalleistung stets gleiche Eingangspegel anliegen. Der Temperaturgang der ACLR-Detektorausgangsspannung läßt sich somit über eine thermische Kopplung der beiden Dioden in den Detektoren 9 und 15, die als Doppeldioden in einem Gehäuse ausgeführt sind, kompensieren. Der Frequenzgang beziehungsweise der Temperaturgang des Kopplers 2, der VGAs 4+7 und des Mischers 5 werden ausgeregelt.

Die Bandbreite des Zwischenfrequenzfilters 6 muß derart gewählt werden, daß Nutz- und Nachbarkanalsignal ungedämpft passieren können. Die Zeitkonstante der Regelschleife 8-13 sollte zur Einstellung der Regelgeschwindigkeit so bemessen sein, daß die Regelung nicht der Amplitudenmodulation des Sendesignals folgt. Aufgrund der Spreizung des W-CDMA-Signals und der sich daraus ergebenden spektralen Beschaffenheit ist diese Forderung für UMTS-Geräte leicht zu erfüllen.

EDGE-Signale weisen jedoch eine deutlich geringere Bandbreite auf, entscheidend ist hier die kleinste auftretende AM-Komponente. Zudem arbeitet das GSM-System als TDMA-System (Time Division Multiple Access = Zeitmultiplex). Hier geschieht die Aussendung in zyklischen Bursts, das heißt zyklisch auftretenden Zeitperioden, in denen der Sender aktiv ist, gegenüber sonstigen Zeiten, in denen der Sender keine Sendeleistung generiert. Die Regelung sollte andererseits schnell genug sein, um während eines Bursts, vor der eigentlichen Datenübertragung, einen eingeschwungenen Zustand erreichen zu können.

Diese beiden Forderungen aus Bandbreite und Ramping sind gegenläufig. In der vorgeschlagenen Schaltungsanordnung ist daher ein Halteglied 13 vorgesehen, mit dem die schnelle Regelung nach dem Hochregeln des Senderausgangssignals 22 (Up Ramping des Sende-Burstes), jedoch noch vor einsetzender Datenübertragung und damit vor der Amplitudenmodulation, aufgetrennt werden kann und der VGA 7 für den Rest des Burstes mit der eingeregelten Verstärkung betrieben werden kann.

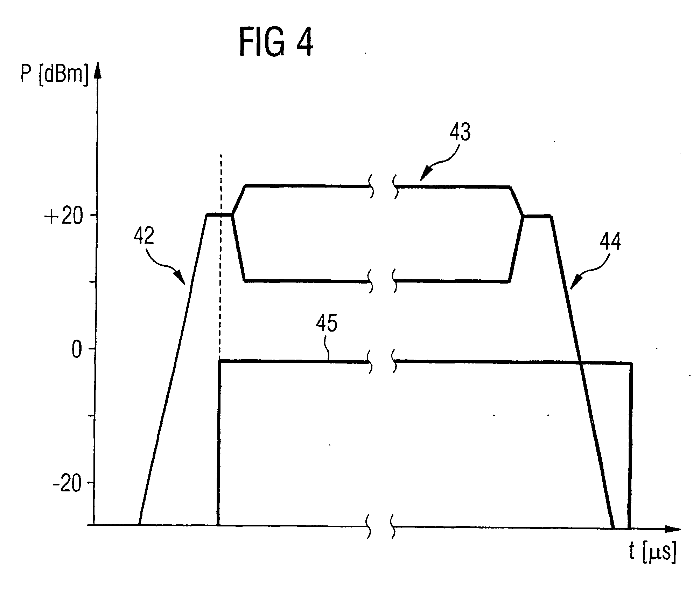

Das dazugehörige Zeitverhalten ist in der Figur 4 für einen EDGE-Burst dargestellt. Diese zeigt die Sendeleistung P[dBm] gegen die Zeit t, wobei von links nach rechts zunächst das Up-Ramping 42 beginnt, in eine Datenübertragungsphase 43 mit Amplitudenmodulationskomponente übergeht und dann mit dem Down-Ramping 44 endet. Gleichzeitig ist mit 45 der Pegel des Steuersignals des Haltegliedes dargestellt, wobei logisch High "Halten" entspricht.

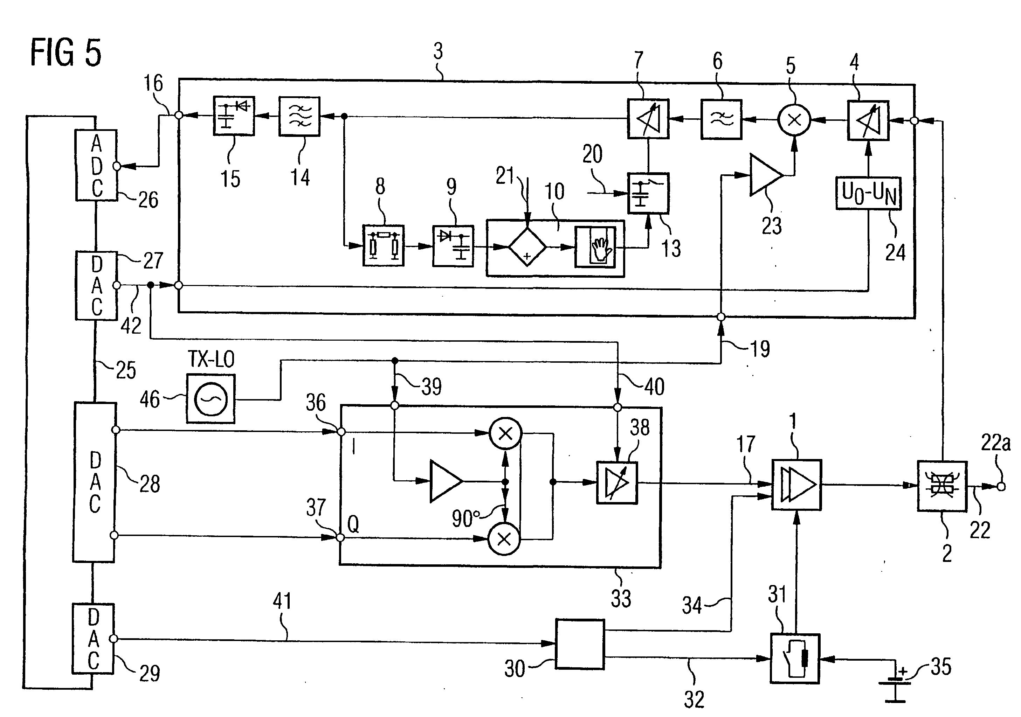

Die Integration der erfindungsgemäßen Schaltungsanordnung aus Figur 3 in einen Direkt-Modulator-Sender ist in der Figur 5 dargestellt.

Die vorgeschlagene Schaltungsanordnung (ACLR-Detektor) ist in einem Funktionsblock 3 zusammengefaßt. Das TX-LO-Signal 39 des Oszillators 46 wird direkt auf der Sendefrequenz über einen Direktmodulator 33 mit dem, im Digitalbereich des Senders generierten Basisband-Signal moduliert und mit einem VGA 38 und dem Leistungsverstärker 1 verstärkt. Der Arbeitspunkt BP sowie die Versorgungsspannung V_{c} der Leistungsverstärker 1 wird über ein Kontrollsignal 41 gesteuert. Die variable Leistungsverstärker-Versorgungsspannung wird mit einem steuerbaren DC/DC-Konverter 31 erzeugt. Die Gewichtung des Verstärkersteuer-Signals 34 und des Verstärkerversorgungsspannungssteuer-Signals 32 kann entweder - wie hier dargestellt - mit Hardware oder auch über zwei getrennte Digital/Analog-Wandler geschehen.

Das ACLR-Detektor-Ausgangssignal 16 dient als Maß für das aktuelle ACLR und wird über einen Analog/Digital-Konverter 26 in das Digitalteil 25 eingelesen und dort zur Steuerung des Leistungsverstärker-Arbeitspunktes und der Leistungsverstärker-Versorgungsspannung ausgewertet. Hierzu werden die beiden Parameter von vorgegebenen Ausgangswerten startend, mit denen die ACLR Anforderungen sicher erfüllt werden, also mit geringem Wirkungsgrad, sukzessive solange verringert, bis gerade das ACLR der Spezifikation abzüglich einer gegebenenfalls vorgegebenen Sicherheit entspricht und der Sender einen hohen Wirkungsgrad erreicht.

Möglich ist auch eine adaptive digitale Vorverzerrung des Sender-Basisbandsignales (AM/AM oder gekoppelte AM/AM + AM/PM) wobei das ACLR-Detektor-Ausgangssignal die Rückführung darstellt.

Da es sich bei dem Detektor-Ausgangssignal 16, ein zeitlich konstantes ACLR vorausgesetzt, um eine Gleichspannung handelt, sind die Anforderungen an den nachfolgenden Auswerter äußerst gering bezüglich A/D-Wandler-Dynamik, A/D-Wandler-Samplingrate, Rechenaufwand, Speicherbedarf und Abgleichaufwand.

Es versteht sich, daß die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

Insgesamt wird also eine Schaltungsanordnung und ein Verfahren zur Arbeitspunkteinstellung des Leistungsverstärkers, vorzugsweise eines mobilen Telekommunikationsendgerätes, mit Modulationsverfahren mit nichtkonstanter Hüllkurve, vorgestellt, wobei durch Vergleich der Nachbarkanalleistung mit der Nutzkanalleistung der Arbeitspunkt des Leistungsverstärkers so eingestellt wird, daß gerade die Schwelle eines Verhältnisses von Nachbarkanalleistung zu Nutzkanalleistung unterschritten wird. Hierzu wird durch eine geeignete Schaltungsanordnung ein Teil des Sendesignals ausgekoppelt, auf einen gleichbleibenden Pegel geregelt und der Pegel des darin enthaltenen Nachbarkanalsignals als Maß für das ACLR herangezogen. Hierdurch bietet sich eine Möglichkeit zur automatischen und wirkungsgradoptimierenden Einstellung des Arbeitspunktes eines Leistungsverstärkers, insbesondere eines mobilen Telekommunikationsendgerätes mit Modulationsverfahren mit nichtkonstanter Hüllkurve, wobei sich der Arbeitspunkt immer gerade so einstellt, daß die ACLR-Anforderungen noch erfüllt und damit ein Betrieb mit maximal möglichem Wirkungsgrad erreicht wird. Besonders vorteilhaft ist hierbei, daß die Bestimmung des ACLR aufgrund des Regelkreises unabhängig von der tatsächlichen Ausgangsleistung des Senders erfolgt.

## Patentansprüche

1. Schaltungsanordnung zur Arbeitspunkteinstellung eines in seinem Arbeitspunkt einstellbaren Leistungsverstärkers Leistungsverstärkers, vorzugsweise eines mobilen Telekommunikationsendgerätes, mit Modulationsverfahren mit nichtkonstanter Hüllkurve mit Mitteln (25, 33, 1) zur Erzeugung eines Sendesignals auf einem Nutzkanal - im folgenden Nutzkanalsignal genannt -, wobei durch Verzerrungen in nachfolgenden Verstärkern auch auf Nachbarkanälen Signalanteile - im folgenden Nachbarkanalsignal genannt - entstehen und des in seinem Arbeitspunkt einstellbaren Leistungsverstärker (1) zur Verstärkung des Sendesignals (17), das an eine Antenne weitergeleitet wird, wobei ein Mittel (2) zur Auskopplung eines Teils des verstärkten Sendesignals - im folgenden Teilsignal genannt - vorgesehen ist und dieses ausgekoppelte Teilsignal über ein Frequenz-Mischglied (5) auf eine feste Zwischenfrequenz gemischt und mittels eines Zwischenfrequenzfilters gefiltert wird und ein Regelkreis (7, 8, 9, 10, 13) vorgesehen ist, um den Leistungspegel dieses gefilterten Teilsignals auf einen vorbestimmten Wert zu halten, weiterhin ist ein Filter (14) zur Auskopplung des Nachbarkanalsignals aus dem konstant gehaltenen Teilsignal mit anschließendem Leistungsdetektor (15) vorgesehen, über dessen Detektorausgangssignal, welches ein direktes Maß für das momentane Verhältnis von Nachbarkanalleistung zu Nutzkanalleistung darstellt, der Arbeitspunkt des Leistungsverstärkers (1) gesteuert wird.

2. Schaltungsanordnung gemäß dem vorstehenden Anspruch 1,
**dadurch gekennzeichnet,**
**daß** der Regelkreis zur Leistungsregelung des Teilsignals einen Verstärker (7), ein Dämpfungsglied (8), einen Leistungsdetektor (9), einen Operationsverstärker (10) aufweist.

3. Schaltungsanordnung gemäß dem vorstehenden Anspruch 2,
**dadurch gekennzeichnet,**
**daß** der Regelkreis zur Leistungsregelung des Teilsignals ein Halteglied (13) aufweist.

4. Schaltungsanordnung gemäß einem der vorstehenden Ansprüche 1 bis 3,
**dadurch gekennzeichnet,**
**daß** zwischen dem Mischglied (5) und dem Verstärker (7) des Regelkreises (7, 8, 9, 10, 13) ein Zwischenfrequenzfilter (6) vorgesehen ist, dessen Bandbreite derart bemessen ist, daß Nutz- und Nachbarkanalsignal ungedämpft passieren können.

5. Schaltungsanordnung gemäß einem der vorstehenden Ansprüche 1 bis 4,
**dadurch gekennzeichnet,**
**daß** das Telekommunikationsendgerät ein CDMA-Handy oder TDMA-Handy ist.

6. Verfahren zur Arbeitspunkteinstellung des Leistungsverstärkers eines mobilen Telekommunikationsendgerätes mit einem Modulationsverfahren mit nichtkonstanter Hüllkurve, indem ein Teil eines verstärkten Sendesignals - nachfolgend Teilsignal genannt -, enthaltend ein Nutzkanalsignal und ein Nachbarkanalsignal, ausgekoppelt, auf eine feste Zwischenfrequenz gemischt, mittels eines Zwischenfrequenzfilters gefiltert und in einem Regelkreis auf einen vorbestimmten Pegel verstärkt wird, wobei anschließend mittels Nachbarkanalfilter das Nachbarkanalsignal aus dem Teilsignal ausgekoppelt wird und einem Leistungsdetektor zugeführt wird, wobei in Abhängigkeit der Leistung des ein Teilsignal enthaltenen Nachbarkanalsignals der Arbeitspunkt des Leistungsverstärkers geregelt wird.

7. Verfahren gemäß dem vorstehenden Verfahrensanspruch 6,
**dadurch gekennzeichnet, daß** zur Regelung des Arbeitspunktes des Leistungsverstärkers die Parameter Basisstrom und Versorgungsspannung bei Bipolartransistoren oder Gate-Spannung und Versorgungsspannung bei Feldeffekttransistoren von vorgegebenen Ausgangswerten, mit denen die Anforderungen an das Nachbarkanalsignal/Nutzkanalsignal-Verhältnis sicher erfüllt wird, startend sukzessive solange verringert werden, bis gerade das Nachbarkanalsignal/Nutzkanalsignal-Verhältnis der Spezifikation, gegebenenfalls abzüglich einer vorgegebenen Sicherheit, entspricht.

8. Verfahren gemäß einem der vorstehenden Verfahrensansprüche 6 bis 7,
**dadurch gekennzeichnet,**
**daß** anschließend an die Mischung des Teilsignals eine Filterung der Zwischenfrequenz stattfindet.

9. Verfahren gemäß einem der vorstehenden Verfahrensansprüche 6 bis 8,
**dadurch gekennzeichnet,**
**daß** die Regelgeschwindigkeit des Regelkreises für den Pegelbereich des Teilsignals so bemessen ist, daß die Regelung von einer Amplitudenmodulation des Sendesignals unbeeinflußt bleibt.

10. Verfahren gemäß einem der vorstehenden Verfahrensansprüche 6 bis 9,
**dadurch gekennzeichnet,**
**daß** es für die Steuerung des Arbeitspunktes des Leistungsverstärkers eines CDMA-Handys oder TDMA-Handys verwendet wird.

11. Verfahren gemäß einem der vorstehenden Verfahrensansprüche 5 bis 10,
**dadurch gekennzeichnet,**
**daß** in Abhängigkeit der Leistung des im Teilsignal enthaltenen Nachbarkanalsignals eine Rückkopplung für eine adaptive Vorverzerrung eines Basisbandsignals (36, 37) erzeugt wird.

12. Verfahren gemäß einem der vorstehenden Verfahrensansprüche 5 bis 10, **dadurch gekennzeichnet, daß** in Abhängigkeit der Leistung des im Teilsignal enthaltenen Nachbarkanalsignals eine Rückkopplung für eine adaptive Vorverzerrung eines Hochfrequenz-Eingangssignals des Leistungsverstärkers (1) erzeugt wird.

## Claims

1. Circuit arrangement for setting the operating point of a power amplifier, whose operating point is settable, preferably of a mobile telecommunication terminal, using modulation methods which feature a non-constant envelope curve, said circuit arrangement having means (25, 33, 1) for generating a transmission signal on a data channel (subsequently referred to as data channel signal), wherein signal portions also occur on adjacent channels (subsequently referred to as adjacent channel signal) due to distortions in subsequent amplifiers, and having the power amplifier (1) whose operating point is settable and which provides for amplifying the transmission signal (17) which is forwarded to an antenna, wherein a means (2) is provided for decoupling a part of the amplified transmission signal (subsequently referred to as part signal), said decoupled part signal being mixed via a frequency mixing element (5) onto a fixed intermediate frequency and filtered by means of an intermediate frequency filter, and an adjustment loop (7, 8, 9, 10, 13) is provided for the purpose of holding the power level of this filtered part signal at a predetermined value, and provision is further made for a filter (14) for decoupling the adjacent channel signal from the part signal which is held constant, and a subsequent power detector (15) whose detector output signal, which represents a direct measure for the momentary ratio of adjacent channel power to data channel power, is used for controlling the operating point of the power amplifier (1).

2. Circuit arrangement as claimed in the preceding claim 1,
**characterised in that**
the adjustment loop for power adjustment of the part signal has an amplifier (7), an attenuation element (8), a power detector (9), and an operation amplifier (10).

3. Circuit arrangement as claimed in the preceding claim 2,
**characterised in that**
the adjustment loop for power adjustment of the part signal has a holding element (13).

4. Circuit arrangement as claimed in one of the preceding claims 1 to 3,
**characterised in that**
an intermediate frequency filter (6) is provided between the mixing element (5) and the amplifier (7) of the adjustment loop (7, 8, 9, 10, 13), the bandwidth of said intermediate frequency filter being dimensioned in such a way that data channel signal and adjacent channel signal can pass through unattenuated.

5. Circuit arrangement as claimed in one of the preceding claims 1 to 4,
**characterised in that**
the telecommunication terminal is a CDMA mobile telephone or TDMA mobile telephone.

6. Method for setting the operating point of the power amplifier of a mobile telecommunication terminal using a modulation method which features a non-constant envelope curve, in which method a part of an amplified transmission signal (subsequently referred to as part signal) containing a data channel signal and an adjacent channel signal is decoupled, mixed onto a fixed intermediate frequency, filtered by means of an intermediate frequency filter, and amplified in an adjustment loop to a predetermined level, wherein the adjacent channel signal is subsequently decoupled from the part signal by means of adjacent channel filters and supplied to a power detector, and wherein the operating point of the power amplifier is adjusted depending on the power of the adjacent channel signal contained in the part signal.

7. Method as claimed in the preceding method claim 6,
**characterised in that**
for adjusting the operating point of the power amplifier, the base current and supply voltage parameters in the case of bipolar transistors, or gate voltage and supply voltage parameters in the case of field effect transistors, are successively reduced starting from predetermined output values which reliably meet the adjacent channel signal/data channel signal ratio requirements, until exactly the adjacent channel signal/data channel signal ratio of the specification, minus a predetermined safety factor if applicable, corresponds.

8. Method as claimed in one of the preceding method claims 6 to 7,
**characterised in that**
a filtering of the intermediate frequency takes place subsequently to the mixing of the part signal.

9. Method as claimed in one of the preceding method claims 6 to 8,
**characterised in that**
the adjustment speed of the adjustment loop for the level range of the part signal is dimensioned in such a way that the adjustment remains unaffected by an amplitude modulation of the transmission signal.

10. Method as claimed in one of the preceding method claims 6 to 9,
**characterised in that**
it is used for the control of the operating point of the power amplifier of a CDMA mobile telephone or TDMA mobile telephone.

11. Method as claimed in one of the preceding method claims 5 to 10,
**characterised in that**
a feedback for an adaptive predistortion of a baseband signal (36, 37) is generated depending on the power of the adjacent channel signal which is contained in the part signal.

12. Method as claimed in one of the preceding method claims 5 to 10,
**characterised in that**
a feedback for an adaptive predistortion of a highfrequency input signal of the power amplifier (1) is generated depending on the power of the adjacent channel signal which is contained in the part signal.

## Revendications

1. Circuit permettant de régler le point de fonctionnement d'un amplificateur de puissance, dont le point de fonctionnement est réglable, préférentiellement d'un terminal mobile de télécommunication, ayant un procédé de modulation à enveloppante non constante, comportant des moyens (25, 33, 1) destinés à produire un signal d'émission sur un canal utile - appelé, dans ce qui suit, signal du canal utile -, des composantes de signal - appelées, dans ce qui suit, signal des canaux adjacents - apparaissant également sur des canaux adjacents en raison de distorsions dans les amplificateurs suivants et un amplificateur de puissance (1), dont le point de fonctionnement est réglable, destiné à amplifier le signal d'émission (17) appliqué à une antenne, un moyen (2) permettant de dévier une partie du signal d'émission amplifié - appelé, dans ce qui suit, signal partiel - étant prévu et ce signal partiel dévié étant mélangé, dans un étage mélangeur de fréquences (5), sur une fréquence intermédiaire fixe et étant filtré au moyen d'un filtre à fréquence intermédiaire et un circuit de régulation (7, 8, 9, 10, 13) étant prévu pour maintenir le niveau de puissance de ce signal partiel filtré sur une valeur donnée, en outre, il est prévu un filtre (14), destiné à séparer le signal des canaux adjacents du signal partiel maintenu constant, suivi d'un détecteur de puissance (15), dont le signal de sortie, qui constitue une mesure directe pour le rapport actuel entre la puissance des canaux adjacents et la puissance du canal utile, règle le point de fonctionnement de l'amplificateur de puissance (1 ).

2. Circuit selon la revendication 1 précédente
**caractérisé par le fait**
**que** la boucle de régulation destinée à la régulation de la puissance du signal partiel comporte un amplificateur (7), un élément d'affaiblissement (8), un détecteur de puissance (9), un amplificateur opérationnel (10).

3. Circuit selon la revendication précédente 2
**caractérisé par le fait**
**que** la boucle de régulation destinée à la régulation de la puissance du signal partiel comporte un élément de maintien (13).

4. Circuit selon l'une des revendications précédentes 1 à 3
**caractérisé par le fait**
**qu'**il est prévu, entre l'élément mélangeur (5) et l'amplificateur (7) de la boucle de régulation (7, 8, 9, 10, 13), un filtre (6) à fréquence intermédiaire dont la largeur de bande est dimensionnée de telle manière que le signal du canal utile et le signal des canaux adjacents puissent le traverser sans affaiblissement.

5. Circuit selon l'une des revendications précédentes 1 à 4
**caractérisé par le fait**
**que** le terminal de télécommunication est un poste portable à AMDC (ou, en anglais, CDMA) ou un poste portable à AMRT (ou, en anglais, TDMA).

6. Procédé permettant de régler le point de fonctionnement de l'amplificateur de puissance d'un terminal de télécommunication mobile ayant un procédé de modulation à enveloppante non constante, dans lequel une partie du signal d'émission amplifié - appelé, dans ce qui suit, signal partiel ― comprenant un signal de canal utile et un signal de canaux adjacents, est déviée, mélangée sur une fréquence intermédiaire fixe, filtrée au moyen d'un filtre à fréquence intermédiaire et amplifiée à un niveau donné dans une boucle de régulation, le signal des canaux adjacents étant ensuite, au moyen d'un filtre des canaux adjacents, extrait du signal partiel et appliqué à un détecteur de puissance, le point de fonctionnement de l'amplificateur de puissance étant réglé en fonction de la puissance du signal des canaux adjacents contenue dans le signal partiel.

7. Procédé selon la revendication précédente 6 concernant le procédé
**caractérisé par le fait**
**que**, pour le réglage du point de fonctionnement de l'amplificateur de puissance, les paramètres courant de base et tension d'alimentation, dans le cas de transistors bipolaires, ou tension de grille et tension d'alimentation, dans le cas de transistors à effet de champ, sont diminués successivement, en partant de valeurs de départ données, avec lesquelles les conditions imposées au rapport signal des canaux adjacents/signal du canal utile sont satisfaites avec certitude, jusqu'à ce que le rapport signal des canaux adjacents/signal du canal utile corresponde tout juste à la spécification, le cas échéant, diminuée d'une sécurité donnée.

8. Procédé selon l'une des revendications précédentes 6 à 7 concernant le procédé
**caractérisé par le fait**
**que**, après le mélange du signal partiel, il se produit un filtrage de la fréquence intermédiaire.

9. Procédé selon l'une des revendications précédentes 6 à 8 concernant le procédé
**caractérisé par** l e fait
que la vitesse de régulation de la boucle de régulation pour la plage du signal partiel est dimensionnée de telle sorte que la régulation n'est pas influencée par une modulation en amplitude du signal d'émission.

10. Procédé selon l'une des revendications précédentes 6 à 9 concernant le procédé
**caractérisé par le fait**
**qu'**il est utilisé pour la commande du point de fonctionnement de l'amplifica-teur de puissance d'un poste portable à AMDC (ou, en anglais, CDMA) ou d'un poste portable à AMRT (ou, en anglais, TDMA).

11. Procédé selon l'une des revendications précédentes 5 à 10 concernant le procédé
**caractérisé par le fait**
**que**, en fonction de la puissance du signal des canaux adjacents contenue dans le signal partiel, on provoque une réinjection pour une prédistorsion adaptative d'un signal de bande de base (36, 37).

12. Procédé selon l'une des revendications précédentes 5 à 10 concernant le procédé
**caractérisé par le fait**
**que**, en fonction de la puissance du signal des canaux adjacents contenue dans le signal partiel, on provoque une réinjection pour une prédistorsion adaptative d'un signal d'entrée à haute fréquence de l'amplificateur de puissance (1).
